Europäisches Patentamt

European Patent Office

Office européen des brevets

(19)

(11) **EP 1 229 388 A2**

(12) **EUROPEAN PATENT APPLICATION**

(43) Date of publication:
   **07.08.2002 Bulletin 2002/32**

(51) Int Cl.[7]: **G03F 7/00**, C09J 7/02

(21) Application number: **02002275.2**

(22) Date of filing: **30.01.2002**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: **30.01.2001 JP 2001020946**<br><br>(71) Applicant: **NITTO DENKO CORPORATION**<br>**Osaka (JP)** | (72) Inventor: **Toyoda, Eiji,**<br>**c/o Nitto Denko Corporation**<br>**Ibaraki-shi, Osaka (JP)**<br><br>(74) Representative: **Grünecker, Kinkeldey,**<br>**Stockmair & Schwanhäusser Anwaltssozietät**<br>**Maximilianstrasse 58**<br>**80538 München (DE)** |

(54) **Adhesive tape and process for removing photoresist**

(57)   An adhesive tape for the removal of a resist includes a curing adhesive layer having an initial tensile modulus of not smaller than 10 MPa at 100°C after cured provided on a supporting base material, and/or an adhesive layer provided on a supporting base material having a flexural stiffness of not smaller than $1 \times 10^{-4}$ (N·m) per unit width.

EP 1 229 388 A2

**Description**

Background of the Invention

1. Field of the Invention

The present invention relates to an adhesive tape or sheet (hereinafter simply referred to as "adhesive tape") for use in the removal of unnecessary resist material from precision-machined parts as semiconductor, thin film magnetic head, circuit, print circuit board, mask and lead frame during the production of these precision-machined parts and a process for the removal of a resist using this adhesive tape.

The invention will be described hereinafter with reference to production of semiconductor device. The invention is not limited to its usage so far as the article to which it is applied has a resist material present thereon. However, the invention is preferably used particularly in the removal of unnecessary resist material from the wafer after plating or etching during the production of semiconductor device.

2. Description of the Related Art

In the process for the production of semiconductor device, a resist material is applied to a silicon wafer. The silicon wafer is then subjected to an ordinary photographic process to form a predetermined resist film image thereon. The silicon wafer is then etched with this resist film image as a mask. The unnecessary resist material was then removed to form a predetermined circuit. Subsequently, in order to form another circuit, a resist material is again applied to the silicon wafer. This cycle is repeated. In the case where a circuit is formed on any other various substrates (boards), too, the formation of a resist film image is followed by the removal of unnecessary resist material.

The removal of unnecessary resist material is normally accomplished by the use of a solvent and a chemical. However, there is a problem that the use of harmful chemicals deteriorates the working atmosphere and it requires a troublesome environmental measure to dispose the waste liquid. In particular, the plating step in the formation of various bumps involves the use of a resist material having a thickness as great as from about 20 μm to 120 μm that needs much time to be removed with a large amount of a chemical. The remaining of the resist after the removal of the chemical, too, causes a problem.

A method has thus been recently proposed which comprises sticking adhesive tape made of a high molecular polymer to the upper surface of a resist film image, subjecting the material to a specific treatment such as heat treatment, and then peeling the adhesive tape and the resist material integrally (as in Japanese Patent Laid-Open No. 1992-345015).

However, the method involving the use of such an adhesive tape is disadvantageous in that peeling cannot be fairly effected depending on the kind of the resist to be peeled. In particular, when the thickness of the resist film exceeds 10 μm, the resist can be often difficultly peeled with the conventional adhesive tape for the removal of a resist.

Summary of the Invention

An object of the invention is to allow even a resist material having such a thickness to be fairly peeled.

The inventors made extensive studies of solution to these problems. As a result, it was found that peeling can be easily effected under heating conditions and the use of an adhesive tape having an adhesive layer which maintains a high elasticity even under heating conditions after cured makes it possible to improve the peelability of the resist. It was further found that the use of an adhesive tape comprising such an adhesive layer provided on a supporting base material having a high flexural stiffness makes it possible to further improve the peelability of the resist.

The invention lies in an adhesive tape for the removal of a resist comprising a curing adhesive layer (i.e., an adhesive layer to be subjected to curing) provided on a supporting base material, the curing adhesive layer exhibiting an initial tensile modulus of not smaller than 10 MPa at 100°C after cured, an adhesive tape for the removal of a resist comprising an adhesive layer provided on a supporting base material having a flexural stiffness of not smaller than $1 \times 10^{-4}$ (N·m) per unit width, an adhesive tape for the removal of a resist comprising in combination the adhesive layer and the supporting base material, a process for the removal of a resist which comprises applying an adhesive tape to an article on which a resist film image is present, and then peeling off the adhesive tape and the resist film image together from the article, and the process for the removal of a resist according to the invention, wherein peeling is effected under conditions of heating to a temperature of not lower than 50°C.

Detailed Description of the Invention

In the invention, an example of the article on which a resist material is present is one obtained by a process which comprises applying a known resist material to an article such as semiconductor substrate (board) and glass substrate (board), subjecting the coated article to an ordinary photographic process to form a predetermined resist pattern thereon, and then subjecting the article to a processing such as metal plating and etching on the opening thereof with this resist material as a mask. In the case where the article is subjected to metal plating, a negative-working liquid resist or dry film resist is preferably formed to a thickness of from 10 μm to 150 μm in most cases. The resist material having such a thickness cures when irradiated with ultraviolet rays during patterning and thus can difficultly be peeled off together with a tape at room temperature.

However, since the resist material which has cured is thermoplastic, it becomes soft and exhibits a deteriorated adhesivity to the substrate when heated. Thus, the resist material can be easily peeled off from the substrate. The peeling temperature depends on the resist material to be peeled but is normally from 50°C to 200°C, preferably from 80°C to 150°C. However, since the adhesive incorporated in an ordinary adhesive tape for the removal of a resist becomes plasticized under these heating conditions similarly to the resist material, the peeling stress can be difficultly transferred to the surface of the resist material, making it impossible to fairly peel off the resist material from the substrate. It was found that this problem can be solved by the use of a material which maintains a high elasticity even under heating conditions as an adhesive layer. In this arrangement, the peeling stress can be concentrated onto the resist material, giving good results in peeling. It was thus found that the use of an adhesive tape having an adhesive layer which exhibits an initial tensile modulus of not smaller than 10 MPa, preferably from about 20 MPa to 200 MPa at 100°C after cured makes it possible to fairly peel off the resist material from the substrate.

The adhesive tape to be used herein is in the form of a sheet or tape comprising an adhesive layer provided on a supporting base material normally to a thickness of from 20 μm to 150 μm. The surface of the supporting base material is normally subjected to physical surface treatment such as corona discharge or undercoating with an adhesivity-providing layer for the purpose of securing adhesivity to the adhesive layer. In order to allow the adhesive layer to fairly follow the unevenness on the substrate during sticking, an interlayer made of various polymers such as acrylic polymer and rubber-based polymer or a pressure-sensitive adhesive mainly composed of these polymers may be provided interposed between the supporting base material and the adhesive layer for the removal of a resist to a predetermined thickness. The supporting base material to be used herein is not specifically limited. For example, a plastic film made of a polyethylene, polypropylene, polyethylene terephthalate, acetyl cellulose or the like having a thickness of normally from 25 μm to 500 μm is preferably used. A supporting base material having a great flexural stiffness is particularly preferred. In some detail, the supporting base material preferably exhibits a flexural stiffness of not smaller than $1 \times 10^{-4}$ (N·m), more preferably from not smaller than $5 \times 10^{-4}$ to not greater than $1 \times 10^{-1}$ (N·m), per unit width. The use of such a supporting base material makes it possible to peel off the resist material from the substrate more uniformly. The term "flexural stiffness" as used herein is meant to indicate the degree of difficulty for an object in being deformed due to bending as referred to in the art of materials dynamics. The flexural stiffness is represented by the product of the tensile modulus E and the second moment of area I of the film. The flexural stiffness is proportional to the third power of the thickness of the film to be bent and can be determined by calculation if the kind and shape of the film are determined (see Equation 1).

$$\text{Flexural stiffness} = E(N/m^2) \times I(m^4) \quad \text{(Eq. 1)}$$

where $I = 1/12 \times b \times h^3$ (b: width of film to be bent; h: thickness of film to be bent)

The adhesive layer to be used herein is not specifically limited. A curing adhesive which cures to become integrated to the resist material when irradiated with light or otherwise treated is preferably used. In particular, a photo-setting adhesive comprising a photopolymerizable compound and a photopolymerization initiator incorporated in an acryl polymer is preferably used.

As such a polymer there may be used any known polymer which can be used in pressure-sensitive adhesives. From the standpoint of development of high elasticity during heating, it is preferred that the polymer comprise a methacrylic acid alkyl ester in a proportion of not smaller than 50% by weight based on the total composition. This methacrylic polymer can be obtained by allowing a methacrylic acid alkyl ester and an acrylic acid alkyl ester as main monomers to undergo ordinary polymerization such as solution polymerization, emulsion polymerization, suspension polymerization and bulk polymerization with a carboxyl group or hydroxyl group-containing monomer or other reactive functional group-containing monomers. The molecular weight of the methacrylic polymer formed by these monomers is preferably from 10,000 to 1,500,000, particularly from 30,000 to 300,000 as calculated in terms of weight-average molecular weight.

As such a polymerizable compound there may be used one which can cure when provided with light or thermal energy, preferably a photosetting compound. Such a compound is a nonvolatile compound having one or more unsaturated double bonds which can cure when irradiated with light. The amount of the photopolymerizable compound to be used is preferably from not smaller than 10 parts by weight to not greater than 200 parts by weight based on 100 parts by weight of the high molecular polymer.

Examples of such a polymerizable compound include phenoxypolyethylene glycol (meth)acrylate, ε-caprolactone (meth)acrylate, polyethylene glycol di(meth)acrylate, polypropylene glycol di(meth)acrylate, trimethylolpropane tri(meth)acrylate, dipentaerythritol hexa(meth)acrylate, urethane (meth)acrylate, epoxy (meth)acrylate, and oligoester (meth)acrylate. One or more of these polymerizable compounds may be used. In order to enhance the elasticity of the adhesive layer during heating after cured, one or more of these polymerizable compounds to be used each have three or four unsaturated double bonds per molecule. As the polymerization initiator, particularly photopolymerization initiator there may be mainly used a compound which generates a radical when irradiated with light such as ultraviolet rays, such as benzylmethyl ketal, benzoin, dibenzyl, thioxanthone compound and benzoin ethyl ether.

In order to reduce the content of low molecular components in the adhesive after cured and hence improve the cohesive force of the adhesive, the adhesive may comprise a polyfunctional compound such as polyfunctional epoxy compound, polyisocyanate compound and aziridine compound incorporated therein in a proper amount. The adhesive may further comprise various additives such as tackifier, colorant and age resistor incorporated therein so far as the effect of the invention cannot be impaired.

The best embodiment of the invention is an adhesive tape for the removal of a resist comprising a curing adhesive layer having an initial tensile modulus of not smaller than 10 MPa at 100°C after cured provided on a supporting base material having a flexural stiffness of not smaller than $1 \times 10^{-4}$ (N·m) per unit width as defined above.

The process to which the process for the removal of a resist of the invention is not specifically limited. In particular, however, the process for the removal of a resist of the invention can be employed in the process for the production of precision-machined parts such as semiconductor, thin film magnetic head, circuit, print circuit board, mask and lead frame. Accordingly, the invention provides a process for the production of various precision-machined parts including at least such a process for the removal of a resist and a precision-machined part produced by such a process for the removal of a resist such as semiconductor, thin film magnetic head, circuit, print circuit board, mask and lead frame.

The invention will be further described in the following examples. The resist film image A to be peeled in the examples has been formed on a semiconductor wafer by the method described in Reference Example 1.

REFERENCE EXAMPLE 1

An electrode portion for connection to the exterior and an insulating portion were formed on the surface of a silicon wafer on which a semiconductor element had been formed. A negative-working dry film resist (thickness: 120 μm) was then stuck to the surface of the silicon wafer. The silicon wafer was then subjected to ordinary exposure and development to form a pattern thereon. Thereafter, the silicon wafer was copper-plated on the surface thereof with this resist pattern as a mask to a thickness of 110 μm. The image pattern thus formed on the silicon wafer is referred to as "resist film image A".

EXAMPLE 1

200 g of a 35% toluene solution of Acryl Polymer A (weight-average molecular weight: 110,000; weight-average molecular weight (Mw) /number-average molecular weight (Mn) = 2) made of a 40/25/25/10 (by weight) copolymer of methyl methacrylate, ethyl methacrylate, n-butyl methacrylate and acrylic acid which had been synthesized by an ordinary method and a toluene solution of 10 g of a polyethylene glycol 400 diacrylate (NK Ester A-400, produced by Shinnakamura Chemical Co., Ltd.), 10 g of a trimethylolpropane triacrylate (A-TMPT, produced by Shinnakamura Chemical Co., Ltd.), 10 g of tetramethylolmethane triacrylate (A-TMM3, produced by Shinnakamura Chemical Co., Ltd.), and 2 g of benzyldimethyl ketal (Irgacure 651, produced by Ciba Specialty Chemicals Co., Ltd.) were applied to a polyester supporting film (N100G50, produced by Mitsubishi Chemical Polyester Film Co., Ltd.; flexural stiffness per unit length: $4.2 \times 10^{-5}$ (N·m)) having a thickness of 50 μm, and then each dried at a temperature of 130°C in a drying oven for 3 minutes to form an adhesive layer thereon to a thickness of 50 μm. Thus, an adhesive tape for the removal of a resist was prepared. The adhesive layer thus obtained exhibited an initial tensile modulus (Young' s modulus) of 32 MPa at 100°C after cured.

Subsequently, the adhesive tape thus obtained was stuck to the resist film image A on the semiconductor wafer under heating to 100°C under a pressure roller. The adhesive tape was then irradiated with ultraviolet rays from a high voltage mercury vapor lamp at a dosage of 1 J/cm$^2$ to become cured. Thereafter, the adhesive tape and the image A were together peeled off from the wafer to remove the image A from the wafer. The semiconductor wafer was then visually observed to have been fully freed of resist material. However, a resist material residue having a thickness as small as scores of micrometers was observed in the vicinity of the border of the undercoat layer with the copper plate column under microscope.

EXAMPLE 2

A curing adhesive tape for the removal of a resist was prepared in the same manner as in Example 1 except that as the supporting film there was used a polyester film (A4100, produced by TOYOBO CO., LTD.; flexural stiffness per unit length: $6.5 \times 10^{-4}$ (N·m)) having a thickness of 125 μm. The resist film image A was peeled off from the wafer in the same manner as in Example 1. The semiconductor wafer was then visually observed to have been fully freed of resist material. No resist material residue was observed even under microscope.

EXAMPLE 3

A curing adhesive tape for the removal of a resist was prepared in the same manner as in Example 1 except that 100 g of a 20% toluene solution of Acryl Polymer B (weight-average molecular weight: 820,000; weight-average molecular weight (Mw)/number-average molecular weight (Mn) is nearly equal to 4) made of a 85/15/3 (by weight) copolymer of n-butyl acrylate, acrylnitrile and acrylic acid which had been synthesized by an ordinary method and a toluene solution of 6 g of an urethane acrylate (U-N-01, produced by Shinnakamura Chemical Co ., Ltd.), 0.6 g of an isocyanate crosslinking agent (Colonate L, produced by NIPPON POLYURETHANE INDUSTRY CO., LTD.) and 0.6 g of benzylmethyl ketal (Irgacure 651, produced by Ciba Specialty Chemicals Co., Ltd.) were used as adhesive solutions. The adhesive layer thus obtained exhibited an initial tensile modulus (Young's modulus) of 2.5 MPa at 100°C after cured. The resist film image A was peeled off from the semiconductor wafer in the same manner as in Example 1. The semiconductor wafer was then visually observed to have been fully freed of resist material. However, a resist material residue having a thickness as small as scores of micrometers was observed in the vicinity of the border of the undercoat layer with the copper plate column under microscope.

COMPARATIVE EXAMPLE 1

The adhesive solution as used in Example 3 was applied to the supporting film having a thickness of 50 μm as used in Example 1 to prepare a photosetting adhesive tape for the removal of a resist having a thickness of 50 μm. The resist film image A was peeled off from the wafer in the same manner as in Example 1. As a result, little or no resist material was removed. An interfacial exfoliation occurred between the adhesive tape and the surface of the resist material.

COMPARATIVE EXAMPLE 2

The resist film image A was peeled off from the substrate in the same manner as in Example 3 except that the temperature of the substrate during peeling was the same as room temperature . As a result, no resist material was removed from the substrate.
In accordance with the invention, the initial tensile modulus of the adhesive layer which has cured is predetermined to a high value and/or the flexural stiffness of the supporting base material is enhanced. In this arrangement, the peeling stress can be concentrated onto the surface of the resist material, enabling uniform peeling. Accordingly, a process for assuring the removal of the resist material, particularly one having a great thickness, can be provided.
This application is based on Japanese patent application JP 2001-020946, filed January 30, 2001, the entire content of which is hereby incorporated by reference, the same as if set forth at length.

**Claims**

1. An adhesive tape for removing a resist, which comprises: a supporting base material; and a curing adhesive layer provided on the supporting base material, wherein the curing adhesive layer exhibits an initial tensile modulus of not smaller than 10 MPa at 100°C after cured.

2. An adhesive tape for removing a resist, which comprises: a supporting base material; and an adhesive layer provided on the supporting base material, wherein the supporting layer has a flexural stiffness per unit width of not smaller than $1 \times 10^{-4}$ N·m.

3. The adhesive tape for removing a resist according to Claim 1, wherein the supporting layer has a flexural stiffness per unit width of not smaller than $1 \times 10^{-4}$ N·m.

4. The adhesive tape for removing a resist according to Claim 1, wherein the curing adhesive layer exhibits an initial tensile modulus of from 20 MPa to 200 MPa at 100°C after cured.

5. The adhesive tape for removing a resist according to Claim 2, wherein the supporting layer has a flexural stiffness per unit width of $5 \times 10^{-4}$ to $1 \times 10^{-1}$ N·m.

6. A process for removing a resist, which comprises: applying an adhesive tape according to Claim 1 to an article on which a resist film image is present; and peeling off the adhesive tape and the resist film image together from the article.

7. The process for removing a resist according to Claim 6, wherein the peeling is effected under heating at a temperature of not lower than 50°C.

8. The process for removing a resist according to Claim 6, wherein a resist film having the resist film image has a thickness exceeding 10 μm.